# FASCICULE DE BREVET EUROPEEN

(11) **EP 2 764 762 B1**
(45) Date de publication et mention de la délivrance du brevet: **11.04.2018**
(21) Numéro de dépôt: 12779111.9
(22) Date de dépôt: 03.10.2012
(51) Int. Cl.: H05K 7/14, H04L 12/931

(54) **EQUIPEMENT INFORMATIQUE A INTRODUIRE DE MANIERE AMOVIBLE DANS UNE ARMOIRE INFORMATIQUE ET A CONNECTER A DES DISPOSITIFS ELECTRONIQUES**
RECHNERVORRICHTUNG ZUM VORÜBERGEHENDEN EINSATZ IN EIN COMPUTERGEHÄUSE UND ZUM ANSCHLUSS AN ELEKTRONISCHE VORRICHTUNGEN
COMPUTER EQUIPMENT TO BE REMOVABLY INSERTED INTO A COMPUTER CABINET AND TO BE CONNECTED TO ELECTRONIC DEVICES

(30) Priorité: 07.10.2011 FR 1159089
(43) Date de publication de la demande: 13.08.2014
(73) Titulaire: Bull SAS, 78340 Les Clayes-sous-Bois (FR)
(72) Inventeur: GERPHAGNON, Jean-Olivier, F-38180 Seyssins (FR); BOZGA, Liana, F-38240 Meylan (FR); LAMBERT, Cédric, F-38160 Saint Romans (FR)
(74) Mandataire: Santarelli
(86) Numéro de dépôt international: PCT/FR2012/052240
(87) Numéro de publication internationale: WO 2013/050703

(56) Documents cités:
- EP-A1- 1 898 578
- EP-A2- 1 280 363
- US-A1- 2005 233 635
- US-A1- 2006 203 460
- US-A1- 2010 110 632
- US-A1- 2010 248 535
- US-B1- 6 497 578

## Description

La présente invention concerne les équipements informatiques à introduire dans des armoires informatiques de centres d'hébergement informatique ou centres de traitement de données, auxquels peuvent être connectés des dispositifs électroniques.

L'invention concerne également des armoires informatiques pourvues de tels équipements informatiques.

Les centres d'hébergement informatique connus sous les terminologies anglophones « Data Center » ou « Server Cluster » sont des ensembles regroupant notamment des serveurs, des unités de stockage de données et des équipements de télématique prenant la forme de rangées d'armoires informatiques (« racks » en anglais) dans lesquelles sont installés des équipements informatiques de manière amovible.

Les centres de traitement de données rassemblent généralement des centaines, parfois même des milliers de dispositifs électroniques à interconnecter via les équipements informatiques.

On connaît des équipements informatiques à introduire de manière amovible dans des armoires informatiques, lesquels équipements présentent un contour pourvu de quatre côtés, respectivement un premier côté, un deuxième côté opposé audit premier côté, un troisième côté et un quatrième côté opposé audit troisième côté.

Ces équipements présentent généralement des encombrements prédéterminés, voire standards, dont la taille est souvent notée U (1U, 2U, 3U, etc.). Ces encombrements sont définis par des distances prédéterminées entre le troisième côté et le quatrième côté de chaque équipement informatique ainsi qu'une hauteur également prédéterminée.

Ces équipements informatiques sont en outre pourvus d'une pluralité de ports de connexion ayant chacun des dimensions prédéterminées. Ces ports de connexion sont disposés sur le premier côté de chaque équipement et sont chacun configurés pour interconnecter un dispositif électronique à un équipement informatique.

L'encombrement de chaque équipement informatique étant standardisé, le nombre de ports de connexion est par conséquent limité, le nombre variant en fonction du type de port de connexion. Ainsi, pour un équipement informatique ayant un encombrement de 1U, le premier côté de cet équipement peut par exemple être pourvu de quarante-huit ports du type RJ45 ou trente-six ports du type InfiniBand™.

La demande de brevet américain 2010/110632 décrit un équipement informatique conventionnel, présentant un contour pourvu de quatre côtés et comportant une pluralité de ports de connexion disposés chacun sur l'un au moins parmi deux côtés opposés du contour et configuré chacun pour interconnecter l'équipement avec des dispositifs électroniques.

La demande de brevet européen 1 898 578 décrit un équipement informatique conventionnel, similaire à celui décrit dans la demande de brevet américain 2010/110632.

L'invention concerne des équipements informatiques du même type visant à augmenter les capacités d'interconnexion des équipements de l'état de la technique de manière simple, commode et économique.

L'invention a ainsi pour objet, sous un premier aspect, un équipement informatique à introduire de manière amovible dans une armoire informatique et à connecter à des dispositifs électroniques, ledit équipement présentant un contour pourvu de quatre côtés, respectivement un premier côté, un deuxième côté opposé audit premier côté, un troisième côté et un quatrième côté opposé audit troisième côté, avec ledit troisième côté et ledit quatrième coté qui sont distants l'un de l'autre d'une distance prédéterminée ; ledit équipement comportant une pluralité de ports de connexion ayant chacun des dimensions prédéterminées, étant chacun disposé sur l'un au moins desdits premier côté et deuxième côté dudit contour et étant chacun configuré pour interconnecter ledit équipement avec lesdits dispositifs électroniques ; ledit premier côté présente une première longueur et ledit deuxième côté présente une deuxième longueur et au
moins une desdites première longueur et deuxième longueur est supérieure à ladite distance prédéterminée.

L'équipement informatique selon l'invention présente un premier côté et/ou un deuxième côté définissant une face de connexion pourvue des ports de connexion auxquels peuvent être connectés les dispositifs électroniques.

Cette face de connexion est pourvue d'une aire supérieure à une face de connexion de l'équipement informatique antérieur susmentionné.

Cette aire étant représentative du nombre de ports de connexion qui peuvent être disposés sur ce premier côté, l'équipement informatique selon l'invention peut donc comporter un plus grand nombre de ports de connexion que n'en comporte l'équipement informatique antérieur susmentionné (ayant le même type de port de connexion), dans un même encombrement.

L'équipement informatique selon l'invention présente une distance prédéterminée, voire standard, entre son troisième côté et son quatrième côté ainsi qu'une hauteur également prédéterminée, voire standard. L'équipement informatique selon l'invention conserve donc toujours des dimensions prédéterminées, voire standards, dont les unités de taille sont par exemple en U.

Selon les caractéristiques préférées, simples, commodes et économiques de l'équipement selon l'invention :
- lesdits deuxième côté, troisième côté et quatrième côté définissent un espace interne audit équipement et ledit premier côté s'étend entre lesdits troisième côté et quatrième côté à l'intérieur dudit espace interne ;
- lesdits deuxième côté, troisième côté et quatrième côté définissent un espace interne audit équipement et ledit premier côté s'étend entre lesdits troisième côté et quatrième côté et saille dudit espace interne ;
- ledit premier côté présente une première extrémité joignant ledit troisième côté et une deuxième extrémité opposée à ladite première extrémité et joignant ledit quatrième côté; et ledit premier côté saille dudit espace interne ou rentre dans ledit espace interne et se trouve à une distance maximale prédéterminée d'écartement dudit espace interne ou de renfoncement dans ledit espace interne comprise entre environ 10mm et environ 200mm ;
- ladite distance maximale prédéterminée d'écartement ou de renfoncement est égale à environ 100mm ;
- ledit premier côté s'étend entre lesdits troisième côté et quatrième côté suivant une direction générale incurvée ;
- ledit premier côté s'étend entre lesdits troisième côté et quatrième côté suivant une direction générale en sommet ;
- l'équipement présente un encombrement général de nU, soit une deuxième longueur environ égale n fois 457,2mm, une première longueur comprise entre environ 1,05 fois et environ 1,5 fois ladite deuxième longueur ; et/ou
- lesdits ports de connexion sont du même type ou de types différents, notamment du type cuivre et/ou du type optique.

L'invention a aussi pour objet, sous un deuxième aspect, une armoire informatique notamment d'un centre d'hébergement informatique, comportant une pluralité d'équipements informatiques tels que décrits ci-dessus.

L'armoire informatique selon l'invention offre une plus grande capacité informatique que l'armoire informatique antérieure susmentionnée, dans un même encombrement, en particulier grâce à sa capacité d'interconnexion qui est directement liée au nombre de ports de connexion que comporte chaque équipement informatique.

Ces armoires informatiques peuvent être utilisées dans des centres d'hébergement informatique qui sont quant à eux utilisés par de grandes et petites entreprises, des centres de recherches ainsi que des administrations, dans lesquels les besoins en capacité de stockage de calculs augmentent rapidement.

Grâce à l'invention, il est possible de satisfaire à ces besoins sans toutefois augmenter de manière significative le nombre total d'équipements informatiques permettant d'interconnecter les dispositifs électroniques.

En outre, pour une même capacité informatique désirée, le nombre total d'équipements informatiques selon l'invention (et par conséquent d'armoires informatiques) peut être significativement réduit par rapport au nombre total d'équipements informatiques antérieurs susmentionnés.

On va maintenant poursuivre l'exposé de l'invention par la description d'un exemple de réalisation, donnée ci-après à titre illustratif et non limitatif, en référence aux dessins annexés sur lesquels :
- la figure 1 représente, très schématiquement en perspective, une armoire informatique partiellement remplie d'équipements informatiques amovibles ;
- la figure 2 représente, schématiquement en perspective et de manière isolée, un des équipements informatiques visibles sur la figure 1 ; et
- les figures 3 à 5 représentent, schématiquement en perspective, respectivement trois variantes de réalisation de l'équipement informatique illustré sur la figure 2.

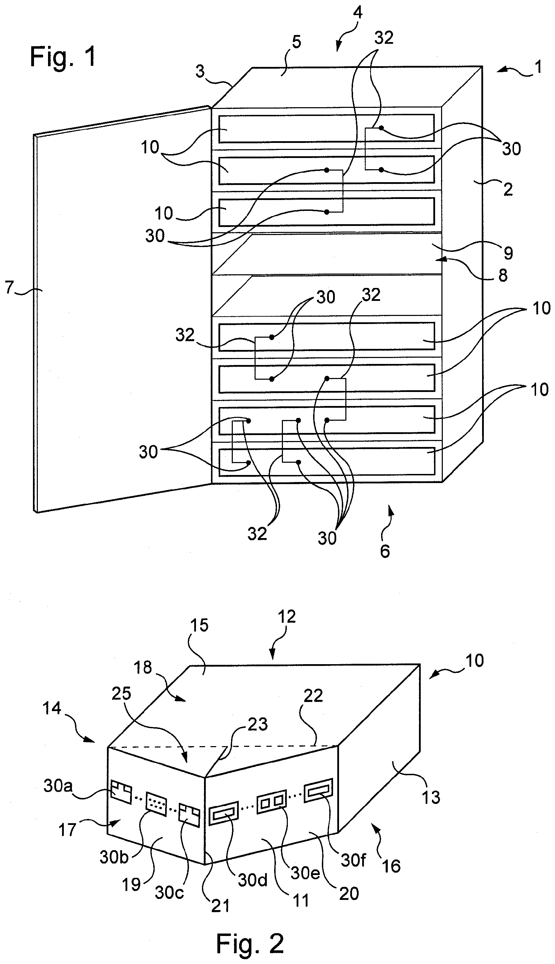

En se référant à la figure 1, on voit une armoire informatique 1 adaptée à être implantée dans un centre d'hébergement informatique (non représenté).

Cette armoire informatique 1 présente une forme générale parallélépipédique.

Cette armoire informatique 1 comporte une première paroi latérale 2, une deuxième paroi latérale 3 opposée à la première paroi latérale 2, une paroi de fond 4, une paroi de dessus 5, une paroi de dessous 6 opposée à la paroi de dessus 5 ainsi qu'une porte 7 mobile et articulée à la deuxième paroi latérale 3.

L'armoire informatique 1 est pourvue d'un espace interne divisé en une pluralité de compartiments 8 qui sont séparés les uns des autres par des plaques de séparation 9 formant support pour des équipements informatiques 10.

En effet, chaque compartiment 8 de l'armoire informatique 1 est configuré pour recevoir de manière amovible un équipement informatique 10.

Chaque équipement informatique 10 comporte une pluralité de dispositifs électroniques (non représentés) ainsi qu'une pluralité de ports de connexion 30, représentés sur la figure 1 très schématiquement.

Ces équipements informatiques 10 sont configurés pour être interconnectés à des dispositifs électroniques que comportent d'autres équipements informatiques 10, voire à des dispositifs électroniques individuels (autrement dit des dispositifs électroniques qui ne sont pas internes à un équipement informatique).

Comme on le verra ci-après plus en détail, ces ports de connexion 30 sont disposés sur une face frontale de chaque équipement informatique 10, lesquels ports 30 peuvent être par exemple du type cuivre, notamment RJ45 et/ou InfiniBand™ et/ou alimentation et/ou du série et/ou USB (pour « Universal Serial Bus » en anglais) et/ou du type optique, notamment fibre.

Comme cela est visible à la figure 1, certains ports de connexion 30 de certains équipements informatiques 10 sont connectés à certains ports de connexion 30 de certains autres équipements informatiques 10 via des éléments filaires de connexion 32.

Ici, les équipements informatiques 10 sont suffisamment introduits en profondeur dans un compartiment 8 respectif de l'armoire 1 pour que la porte 7 de cette armoire 1 puisse être fermée sans être gênée par les éléments filaires de connexion 32.

On va maintenant décrire plus en détail en référence à la figure 2 un des équipements informatiques 10 qui est introduit de manière amovible dans un compartiment 8 de l'armoire informatique 1 illustrée sur la figure 1.

L'équipement informatique 10 illustré sur la figure 2 présente un premier coté 11, un deuxième côté 12 opposé au premier côté 11, un troisième côté 13 ainsi qu'un quatrième côté 14 opposé au troisième côté 13.

Les troisième et quatrième côtés 13 et 14 sont orientés de manière parallèle et sont distants l'un de l'autre d'une distance prédéterminée, ici égale à environ 457,2mm. Cette distance prédéterminée correspond à une dimension standard pour les équipements informatiques, mesurée en nombre de U. Ici, il s'agit d'un équipement informatique 10 d'encombrement 1U.

La deuxième paroi de côté 12 rejoint à la fois la troisième paroi de côté 13 et la quatrième paroi de côté 14 de sorte que la deuxième paroi de côté 12 présente une longueur, appelée aussi deuxième longueur, environ égale à la distance prédéterminée susmentionnée, c'est-à-dire 457,2mm.

On observera que cette distance prédéterminée et cette deuxième longueur correspondent à un encombrement de 19 pouces en terminologie anglo-saxonne.

L'équipement informatique 10 présente en outre une paroi supérieure 15 ainsi qu'une paroi inférieure 16 opposée à la paroi supérieure 15 et rejoignant chacune les quatre côtés 11 à 14.

Ces quatre côtés 11 à 14 présentent une hauteur, définie par la distance entre la jonction de chacun de ces côtés 11 à 14 avec la paroi supérieure 15 et la jonction avec la paroi supérieure 16, qui est identique et prédéterminée conformément à l'encombrement de 1U de l'équipement informatique 10. Autrement dit, la hauteur de chacun de côtés 11 à 14 est environ égale à 44,45mm, soit 1,75 pouces en terminologie anglo-saxonne.

Les quatre côtés 11 à 14 définissent le contour de l'équipement informatique 10.

Ce contour a ici une forme de U fermé ayant un fond, deux branches ainsi qu'une ouverture entre ces deux branches, laquelle ouverture est fermée par un chapeau en forme de sommet.

Le fond du U correspond ici au deuxième côté 12, les branches correspondent respectivement aux troisième et quatrième côtés 13 et 14 et le chapeau en forme de sommet correspond au premier côté 11.

Ainsi, à la différence des deuxième, troisième et quatrième côtés 12 à 14 qui sont rectilignes et plans, le premier côté 11 s'étend entre les troisième et quatrième côtés 13 et 14 suivant une direction générale en sommet.

Autrement dit, ce premier côté 11 présente une première extrémité au niveau d'une première portion 19 rejoignant le quatrième côté 14 et une deuxième extrémité opposée à la première extrémité au niveau d'une deuxième portion 20 rejoignant le troisième côté 13, avec les première et deuxième portions 19 et 20 qui se rejoignent au niveau d'une arête 21.

Le deuxième côté 12, le troisième côté 13 et le quatrième côté 14 définissent un espace interne prédéterminé 18, voire standard puisque la deuxième longueur du deuxième côté 12 correspond à des dimensions standards d'un équipement informatique 1.

Cet espace interne 18 présente, vu de dessus et en section, une forme rectangulaire délimitée, au niveau de l'ouverture du U formé par les deuxième, troisième et quatrième côtés 12 à 14, par une ligne en pointillé 22.

Entre l'ouverture du U et le premier côté 11 est défini un espace interne supplémentaire 25 à l'équipement informatique 10.

Cet espace interne supplémentaire 25 est créé du fait que le premier côté 11 est formé en saillie de l'espace interne 18, c'est-à-dire que le sommet représenté ici par l'arête 21 du premier côté 11 s'étend à l'opposé du deuxième côté 12.

Vu de dessus, l'espace interne supplémentaire 25 présente, en section, une forme triangulaire, dont le sommet du triangle (autrement dit l'arête 21) se trouve à une distance maximale prédéterminée d'écartement 23 de l'espace interne 18 et en particulier de la ligne en pointillé 22.

Cette distance maximale prédéterminée d'écartement 23 peut être comprise entre environ 10mm et environ 200mm. Ici, la distance maximale prédéterminée d'écartement 23 est égale à environ 100mm.

La direction générale dans laquelle s'étend le premier côté 11 fait que ce dernier présente une longueur, aussi appelée première longueur, qui est supérieure à la distance prédéterminée séparant les troisième et quatrième côtés 13 et 14 et donc à la deuxième longueur du deuxième côté 12.

Ici, la première longueur du premier côté 11 est environ égale à 500mm alors que, comme indiqué ci-dessus, la distance prédéterminée et la deuxième longueur du deuxième côté 12 est environ égale à 457,2mm.

De ce fait, le premier côté 11 présente une face de connexion ayant une aire 17 supérieure à celle du deuxième côté 12.

Les ports de connexion 30 sont ici formés par des ports de connexion du type RJ45 30a, des ports de connexion du type série 30b, des ports de connexion du type InfiniBand™ 30c, des ports de connexion du type USB 30d, des ports de connexion du type alimentation 30e et des ports de connexion du type optique 30f.

Ces ports de connexion 30a-30f sont disposés sur le premier côté 11 de l'équipement 10, en partie sur la première portion 19 et en partie sur la deuxième portion 20.

Ces ports de connexion 30a-f s'étendent sur toute la première longueur du premier côté 11 de sorte que l'équipement informatique 10 illustré sur la figure 2 comporte quarante ports de connexion 30a-f de différents types (un certain nombre seulement est représenté pour des questions de lisibilité).

On observera que l'équipement informatique 10 illustré sur la figure 2 présente un encombrement standard de 1U et est malgré tout pourvu de quarante ports de connexion 30a-f alors que l'équipement informatique antérieur susmentionné ne pourrait présenter que trente-six ports de connexion (identiques à ceux de l'équipement informatique 10) pour le même encombrement standard.

L'équipement informatique 10 selon l'invention permet donc d'interconnecter plus de dispositifs électroniques à un tel équipement 10 qu'à un équipement antérieur susmentionné.

On observera en outre qu'une pluralité de tels équipements informatiques 10 est introduite de manière amovible dans l'armoire informatique 1 illustrée sur la figure 1 et qu'une pluralité de telles armoires 1 est adaptée à être implantée dans un centre d'hébergement informatique.

Ainsi, il est possible grâce à l'invention d'augmenter la capacité de connexion informatique sans toutefois augmenter l'encombrement de l'ensemble du centre d'hébergement informatique (non représenté).

On observera en outre que la distance maximale prédéterminée d'écartement entre l'arête 21 du premier côté 11 et l'espace interne 18 et en particulier la ligne en pointillé 22, dépend de l'encombrement de chaque équipement informatique 10 et de l'armoire informatique 1 utilisée, en particulier de la forme des portes 7 qui doivent pouvoir être fermées.

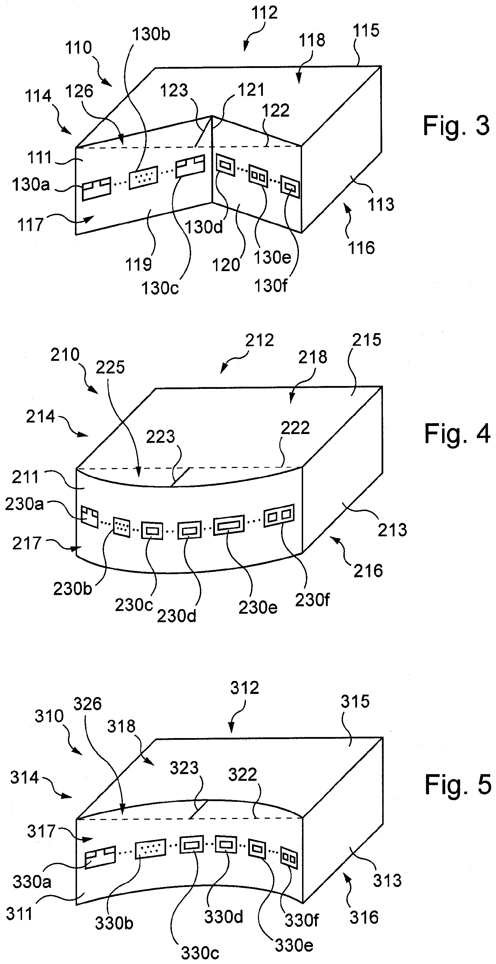

On va maintenant décrire en référence à la figure 3 une variante de réalisation de l'équipement informatique.

D'une manière générale on a employé pour les éléments similaires, les mêmes références utilisées pour l'équipement informatique 10 illustré sur la figure 2 mais additionnées du nombre 100.

L'équipement informatique 110 illustré sur la figure 3 a sensiblement la même forme générale que l'équipement informatique 10 illustré sur la figure 2 et présente sensiblement les mêmes caractéristiques.

En effet, l'équipement informatique 110 présente un premier côté 111, un deuxième côté 112 opposé au premier côté 111, un troisième côté 113 et un quatrième côté 114 opposé au troisième côté 113.

L'équipement informatique 110 présente en outre une paroi supérieure 115 ainsi qu'une paroi inférieure 116 opposée à cette paroi supérieure 115.

L'équipement informatique 110 présente un encombrement également de 1U, c'est-à-dire que la distance prédéterminée séparant les troisième et quatrième côtés 113 et 114 (qui sont en regard et parallèles) est environ égale à 457,2mm et donc la deuxième longueur du deuxième côté 112 est aussi environ égale à 457,2mm.

Le contour défini par les deuxième, troisième et quatrième côtés 112 à 114 présente une forme de U ayant un espace interne 118 et étant fermé par un chapeau en forme de sommet retourné correspondant au premier côté 111.

A la différence de l'équipement informatique 10 illustré sur la figure 2, l'équipement informatique 110 illustré sur la figure 3 est pourvu d'un premier côté 111 qui s'étend suivant une direction générale en sommet et qui saille à l'intérieur de l'espace interne 118.

Ce premier côté 111 présente une première portion 119 et une deuxième portion 120 qui se rejoignent par une arête 121, laquelle arête 121 se trouve dans l'espace interne 118.

Cet espace interne 118 est en outre délimité par la ligne en pointillé 122.

A la différence de l'équipement informatique 10, l'équipement informatique 110 ne présente pas d'espace interne supplémentaire mais plutôt un arrachement partiel de l'espace interne 118.

Cet arrachement partiel est illustré par la référence 126 qui désigne l'espace défini entre la ligne en pointillé 122 et le premier côté 111.

Vu de dessus, cet arrachement 126 présente, en section, une forme triangulaire, dont le sommet du triangle (autrement dit l'arête 121) se trouve à la distance maximale prédéterminée de renfoncement 123 dans l'espace interne 118 et en particulier de la ligne en pointillé 122.

Ici, il s'agit donc d'une distance maximale prédéterminée de renfoncement 126 dans l'espace interne 118 et non pas d'écartement de cet espace interne 118.

Cette distance maximale de renfoncement 123 est environ égale à 100mm.

Tout comme l'équipement informatique 10, l'équipement informatique 110 présente une aire 117 supérieure à l'aire (non représentée) du deuxième côté 112 puisque sa première longueur, ici égale à environ 500mm, est supérieure à la distance prédéterminée séparant les troisième et quatrième côtés 113 et 114 et donc supérieure à la deuxième longueur du deuxième côté 112.

En outre, le premier côté 111 est pourvu de quarante ports de connexion 130a, 130b, 130c, 130d, 130e et 130f.

On va maintenant décrire en référence à la figure 4 une autre variante de réalisation de l'équipement informatique.

D'une manière générale on a employé pour les éléments similaires, les mêmes références utilisées pour l'équipement informatique 10 illustré sur la figure 2 mais additionnées du nombre 200.

L'équipement informatique 210 illustré sur la figure 3 a sensiblement la même forme générale que l'équipement informatique 10 illustré sur la figure 2 et présente sensiblement les mêmes caractéristiques.

En effet, l'équipement informatique 210 présente un premier côté 211, un deuxième côté 212 opposé au premier côté 211, un troisième côté 213 et un quatrième côté 214 opposé au troisième côté 213.

L'équipement informatique 210 présente en outre une paroi supérieure 215 ainsi qu'une paroi inférieure 216 opposée à cette paroi supérieure 215.

L'équipement informatique 210 présente un encombrement également de 1U, c'est-à-dire que la distance prédéterminée séparant les troisième et quatrième côtés 213 et 214 est environ égale à 457,2mm et donc la deuxième longueur du deuxième côté 212 est aussi environ égale à 457,2mm.

Le contour défini par les deuxième, troisième et quatrième côtés 212 à 214 présente une forme de U ayant un espace interne 218 et étant fermé par un chapeau ayant une forme incurvé correspondant au premier côté 211.

A la différence de l'équipement informatique 10 illustré sur la figure 2, l'équipement informatique 210 illustré sur la figure 3 est pourvu d'un premier côté 211 qui s'étend suivant une direction générale incurvée et qui saille à l'extérieur de l'espace interne 218.

Ce premier côté 211 présente un bord qui ne se trouve pas dans l'espace interne 218.

Cet espace interne 218 est en outre délimité par la ligne en pointillé 222.

Tout comme l'équipement informatique 10, l'équipement informatique 210 présente un espace interne supplémentaire 225 au-delà de la ligne en pointillé 222.

Vu de dessus, l'espace interne supplémentaire 225 présente, en section, une forme de voûte dont le bord se trouve à une distance maximale prédéterminée d'écartement 223 de l'espace interne 218, et en particulier de la ligne en pointillé 222, qui est environ égale à 100mm.

La distance maximale prédéterminée d'écartement 223 entre le bord du premier côté 211 et la ligne en pointillé 222 (délimitant l'espace interne 218) est environ égale à 100mm.

Tout comme l'équipement informatique 10, l'équipement informatique 210 présente une aire 217 supérieure à l'aire (non représentée) du deuxième côté 212 puisque sa première longueur, ici égale à environ 513mm, est supérieure à la deuxième longueur du deuxième côté 212.

En outre, le premier côté 211 est pourvu de quarante ports de connexion 230a, 230b, 230c, 230d, 230e et 230f.

On va maintenant décrire en référence à la figure 5 encore une autre variante de réalisation de l'équipement informatique.

D'une manière générale, on a employé pour les éléments similaires, les mêmes références utilisées pour l'équipement informatique 10 illustré sur la figure 2 mais additionnées du nombre 300.

L'équipement informatique 310 illustré sur la figure 3 a sensiblement la même forme générale que l'équipement informatique 10 illustré sur la figure 2 et présente sensiblement les mêmes caractéristiques.

En effet, l'équipement informatique 310 présente un premier côté 311, un deuxième côté 312 opposé au premier côté 311, un troisième côté 313 et un quatrième côté 314 opposé au troisième côté 313.

L'équipement informatique 310 présente en outre une paroi supérieure 315 ainsi qu'une paroi inférieure 316 opposée à cette paroi supérieure 315.

L'équipement informatique 310 présente un encombrement également de 1U, c'est-à-dire que la distance prédéterminée séparant les troisième et quatrième côtés 313 et 314 est environ égale à 457,2mm et donc la deuxième longueur du deuxième côté 312 est aussi environ égale à 457,2mm.

Le contour défini par les deuxième, troisième et quatrième côtés 312 à 314 présente une forme de U ayant un espace interne 318 et étant fermé par un chapeau ayant une forme incurvée (dont la courbure est inversée par la courbure du chapeau de l'équipement informatique 210 illustré sur la figure 4) correspondant au premier côté 211.

A la différence de l'équipement informatique 10 illustré sur la figure 2, l'équipement informatique 310 illustré sur la figure 3 est pourvu d'un premier côté 311 qui s'étend suivant une direction générale incurvée et qui saille à l'intérieur de l'espace interne 318.

Ce premier côté 311 présente un bord qui se trouve dans l'espace interne 318.

Cet espace interne 318 est en outre délimité par la ligne en pointillé 322.

A la différence de l'équipement informatique 10, l'équipement informatique 310 ne présente pas d'espace interne supplémentaire mais plutôt un arrachement partiel de l'espace interne 318.

Cet arrachement partiel est illustré par la référence 326 qui désigne l'espace défini entre la ligne en pointillé 322 et le premier côté 311.

Vu de dessus, cet arrachement 326 présente, en section, une forme de voûte retournée dont le bord se trouve à une distance maximale prédéterminée de renfoncement 323 dans l'espace interne 318, et en particulier de la ligne en pointillé 322, qui est environ égale à 100mm.

Tout comme l'équipement informatique 10, l'équipement informatique 310 présente une aire 317 supérieure à l'aire (non représentée) du deuxième côté 312 puisque sa première longueur, ici égale à environ 513mm, est supérieure à la deuxième longueur du deuxième côté 312.

En outre, le premier côté 311 est pourvu de quarante ports de connexion 330a, 330b, 330c, 330d, 330e et 330f.

Dans une variante non illustrée, ce sont les premier et deuxième côtés de l'équipement informatique qui présentent chacun une longueur, respectivement une première longueur et une deuxième longueur, supérieure à la distance prédéterminée séparant les troisième et quatrième côtés qui sont disposés en regard l'un de l'autre et qui sont parallèles. Le cas échéant, chacun des premier et deuxième côtés peut définir une face de connexion configurée pour accueillir une pluralité de ports de connexion. Les aires respectives des premier et deuxième côtés peuvent être similaires ou différentes, afin d'accueillir respectivement le même nombre de ports ou un nombre différent. Ces ports peuvent être identiques ou différents sur les deux faces. Ces premier et deuxième côtés peuvent alors présenter chacune l'une quelconque des formes illustrées aux figures 2 à 5; ils peuvent avoir la même forme ou des formes différentes.

Dans d'autres variantes non illustrées :
- le premier côté de l'équipement informatique présente d'autres formes que celles visibles sur les figures 2 à 5, par exemple une forme en vague ou en créneau ou en sommet avec plusieurs paliers plats et/ou en rampes ;
- l'équipement informatique ne comporte pas seulement ou pas de port du type RJ45 et/ou du type InfiniBand™ et/ou du type alimentation et/ou du type série et/ou du type USB et/ou du type optique, mais plus généralement des ports de connexion du type optique et/ou cuivre ;
- l'équipement informatique présente un encombrement général différent de 1U illustré sur les figures 2 à 5, par exemple 2U ou 3U ou 4U ou davantage ; plus généralement, l'équipement informatique présente un encombrement général de nU, la deuxième longueur du deuxième côté est environ égale à n fois 457,2mm et la première longueur du premier côté est comprise entre environ 1,05 fois et 1,5 fois cette deuxième longueur ; de sorte à pourvoir disposer de 5% à 25% de ports de connexion de plus que sur un équipement antérieur susmentionné (ayant bien entendu les mêmes ports) ;

- l'armoire informatique ne présente pas une porte plane comme celle illustrée sur la figure 1, mais présente plutôt une forme arrondie, voire triangulaire, voire en vague, voire en créneau ; plus généralement, la forme de la porte de l'armoire informatique peut être configurée de telle sorte à correspondre sensiblement à l'identique à la forme du premier côté de l'équipement informatique ; et/ou
- les armoires informatiques ne sont pas destinées à être implantées dans des centres d'hébergements informatiques, mais plutôt dans des systèmes informatiques industriels plus modestes, par exemple dans des centres de recherches.

On rappelle plus généralement que l'invention ne se limite pas aux exemples décrits et représentés.

## Revendications

1. Equipement informatique à introduire de manière amovible dans une armoire informatique (1) et à connecter à des dispositifs électroniques, ledit équipement (10; 110; 210; 310) présentant un contour pourvu de quatre côtés, respectivement un premier côté (11; 111; 211; 311), un deuxième côté (12; 112; 212; 312) opposé audit premier côté (11; 111; 211; 311), un troisième côté (13; 113; 213; 313) et un quatrième côté (14; 114; 214; 314) opposé audit troisième côté (13; 113; 213; 313), avec ledit troisième côté (13; 113; 213; 313) et ledit quatrième coté (14; 114; 214; 314) qui sont en regard et parallèles et distants l'un de l'autre d'une distance prédéterminée; ledit équipement (10; 110; 210; 310) comportant une pluralité de ports de connexion (30a-f ; 130a-f ; 230a-f ; 330a-f) ayant chacun des dimensions prédéterminées, étant chacun disposé sur l'un au moins desdits premier côté (11; 111; 211; 311) et deuxième côté (12; 112; 212; 312) dudit contour et étant chacun configuré pour interconnecter ledit équipement (10; 110; 210; 310) avec lesdits dispositifs électroniques ; ledit équipement (10; 110; 210; 310) étant **caractérisé en ce que** ledit premier côté (11; 111; 211; 311) présente une première longueur et ledit deuxième côté (12; 112; 212; 312) présente une deuxième longueur et au moins une desdites première longueur et deuxième longueur, à savoir la longueur d'au moins un desdits premier et deuxième côtés pourvu de ladite pluralité de ports de connexion, est supérieure à ladite distance prédéterminée, ledit premier côté et/ou ledit deuxième côté le plus long étant soit incurvé, soit présentant une arête (21 ; 121).

2. Equipement selon la revendication 1, **caractérisé en ce que** lesdits deuxième côté (112; 312), troisième côté (113; 313) et quatrième côté (114 ; 314) définissent un espace interne (118; 318) audit équipement (110; 310) et ledit premier côté (111; 311) s'étend entre lesdits troisième côté (113; 313) et quatrième côté (114; 314) à l'intérieur dudit espace interne (118; 318).

3. Equipement selon la revendication 1, **caractérisé en ce que** lesdits deuxième côté (12; 212), troisième côté (13; 213) et quatrième côté (14; 214) définissent un espace interne (18; 218) audit équipement (10; 210) et ledit premier côté (11; 211) s'étend entre lesdits troisième côté (13; 213) et quatrième côté (14; 214) et saille dudit espace interne (18; 218).

4. Equipement selon l'une des revendications 2 et 3, **caractérisé en ce que** ledit premier côté (11; 111; 211; 311) présente une première extrémité joignant ledit troisième côté et une deuxième extrémité opposée à ladite première extrémité et joignant ledit quatrième côté (514; 114; 214; 314) ; et ledit premier côté (11; 111; 211; 311) saille dudit espace interne (18; 218) ou rentre dans ledit espace interne (118; 318) et se trouve à une distance maximale prédéterminée d'écartement (23; 223) dudit espace interne (18; 218) ou de renfoncement (123; 323) dans ledit espace interne (118; 318) comprise entre environ 10mm et environ 200mm.

5. Equipement selon la revendication 4, **caractérisé en ce que** ladite distance maximale prédéterminée d'écartement ou de renfoncement (23; 123 ; 223 ; 323) est égale à environ 100mm.

6. Equipement selon l'une quelconque des revendications 1 à 5, **caractérisé en ce que** ledit premier côté (211; 311) s'étend entre lesdits troisième côté (213; 313) et quatrième côté (214; 314) suivant une direction générale incurvée.

7. Equipement selon l'une quelconque des revendications 1 à 5, **caractérisé en ce que** ledit premier côté (11; 111) s'étend entre lesdits troisième côté (13; 113) et quatrième côté (14; 114) suivant une direction générale en sommet.

8. Equipement selon l'une quelconque des revendications 1 à 7, **caractérisé en ce qu'**il présente un encombrement général de nU, soit une deuxième longueur environ égale n fois 457,2mm, une première longueur comprise entre environ 1,05 fois et environ 1,5 fois ladite deuxième longueur.

9. Equipement selon l'une quelconque des revendications 1 à 8, **caractérisé en ce que** lesdits ports de connexion (30a-f; 130a-f; 230a-f; 330a-f) sont du même type ou de types différents, notamment du type cuivre et/ou du type optique.

10. Armoire informatique notamment d'un centre d'hébergement informatique, comportant une pluralité d'équipements informatiques (10; 110; 210; 310) selon l'une quelconque des revendications 1 à 9.

## Patentansprüche

1. Rechnervorrichtung zum vorübergehenden Einsatz in ein Computergehäuse (1) und zum Anschluss an elektronische Vorrichtungen, wobei die Vorrichtung (10; 110; 210; 310) eine mit vier Seiten versehene Kontur aufweist, mit jeweils einer ersten Seite (11; 111; 211; 311), einer zweiten Seite (12; 112; 212; 312), die der ersten Seite (11; 111; 211; 311) gegenüberliegt, einer dritten Seite (13; 113; 213; 313) und einer vierten Seite (14; 114; 214; 314), die der dritten Seite (13; 113; 213; 313) gegenüberliegt, wobei die dritte Seite (13; 113; 213; 313) und die vierte Seite (14; 114; 214; 314) einander gegenüberliegen und zueinander parallel sind und um einen vorbestimmten Abstand voneinander entfernt sind, wobei die Vorrichtung (10; 110; 210; 310) eine Vielzahl von Anschlusspunkten (30a-f; 130a-f; 230a-f; 330a-f) umfasst, die jeweils vorbestimmte Dimensionen haben, wobei jeder auf mindestens einer der ersten Seite (11; 111, 211; 311) und zweiten Seite (12; 112; 212; 312) der Kontur angeordnet und jeweils konfiguriert ist, um die Vorrichtung (10; 110; 210; 310) mit den elektronischen Vorrichtungen zusammenzuschließen, wobei die Vorrichtung (10; 110; 210; 310) **dadurch gekennzeichnet ist, dass** die erste Seite (11; 111; 211; 311) eine erste Länge aufweist, und die zweite Seite (12; 112; 212; 312) eine zweite Länge aufweist, und mindestens eine der ersten und zweiten Längen, nämlich die Länge mindestens einer der ersten und zweiten Seiten, die mit der Vielzahl von Anschlusspunkten versehen ist, größer als der vorbestimmte Abstand ist, wobei die längste erste Seite order zweite Seite entweder gekrümmt ist oder eine Kante (21, 121) aufweist.

2. Vorrichtung nach Anspruch 1, **dadurch gekennzeichnet, dass** die zweite Seite (112; 312), dritte Seite (113; 313) und vierte Seite (114; 314) einen Innenraum (118; 318) in der Vorrichtung (110; 310) definieren, und sich die erste Seite (111; 311) zwischen der dritten Seite (113; 313) und der vierten Seite (114; 314) im Inneren des Innenraums (118; 318) erstreckt.

3. Vorrichtung nach Anspruch 1, **dadurch gekennzeichnet, dass** die zweite Seite (12; 212), dritte Seite (13; 213) und vierte Seite (14; 214) einen Innenraum (18; 218) in der Vorrichtung (10; 210) definieren, und sich die erste Seite (11; 211) zwischen der dritten Seite (13; 213) und der vierten Seite (14; 214) und aus dem Innenraum (18; 218) herausragend erstreckt.

4. Vorrichtung nach einem der Ansprüche 2 und 3, **dadurch gekennzeichnet, dass** die erste Seite (11; 111; 211; 311) ein erstes Ende, das an die dritte Seite stößt, und ein zweites Ende, das dem ersten Ende gegenüberliegt und an die vierte Seite (514; 114; 214; 314) stößt, aufweist, und die erste Seite (11; 111; 211; 311) aus dem Innenraum (18; 218) herausragt oder in den Innenraum (118; 318) hineinragt und sich in einem vorbestimmten maximalen Abstand in Entfernung (23; 223) zum Innenraum (18; 218) oder in Versenkung (123; 323) in dem Innenraum (118; 318) zwischen ungefähr 10 mm und ungefähr 200 mm befindet.

5. Vorrichtung nach Anspruch 4, **dadurch gekennzeichnet, dass** der vorbestimmte maximale Abstand in Entfernung oder Versenkung (23; 123; 223; 323) ungefähr gleich 100 mm ist.

6. Vorrichtung nach einem der Ansprüche 1 bis 5, **dadurch gekennzeichnet, dass** sich die erste Seite (211; 311) zwischen der dritten Seite (213; 313) und der vierten Seite (214; 314) in eine allgemeine gekrümmte Richtung erstreckt.

7. Vorrichtung nach einem der Ansprüche 1 bis 5, **dadurch gekennzeichnet, dass** sich die erste Seite (11; 111) zwischen der dritten Seite (13; 113) und der vierten Seite (14; 114) in eine allgemeine Scheitelrichtung erstreckt.

8. Vorrichtung nach einem der Ansprüche 1 bis 7, **dadurch gekennzeichnet, dass** sie einen allgemeinen Platzbedarf von nU aufweist, d.h. eine zweite Länge ungefähr gleich n-mal 457,2 mm, eine erste Länge im Bereich zwischen ungefähr 1,05-mal und 1,5-mal die zweite Länge.

9. Vorrichtung nach einem der Ansprüche 1 bis 8, **dadurch gekennzeichnet, dass** die Anschlusspunkte (30a-f; 130a-f; 230a-f; 330a-f) von demselben Typ oder von unterschiedlichen Typen sind, insbesondere vom Kupfertyp und/oder vom optischen Typ.

10. Computergehäuse, insbesondere eines Datenzentrums, umfassend eine Vielzahl von Rechnervorrichtungen (10; 110; 210; 310) nach einem der Ansprüche 1 bis 9.

## Claims

1. Piece of computer equipment to be introduced removably into a computer cabinet (1) and to be connected to electronic devices, said piece of equipment (10; 110; 210; 310) having a contour provided with four sides, respectively a first side (11; 111; 211; 311), a second side (12; 112; 212; 312) opposite said first side (11; 111; 211; 311), a third side (13; 113; 213; 313) and a fourth side (14; 114; 214; 314) opposite said third side (13; 113; 213; 313), with said third side (13; 113; 213; 313) and said fourth side (14; 114; 214; 314) facing and in parallel and remote from one another by a predetermined distance; said piece of equipment (10; 110; 210; 310) having a plurality of connection ports (30a-f; 130a-f; 230a-f; 330a-f) each having predetermined dimensions, each one being disposed on at least one of said first side (11; 111; 211; 311) and second side (12; 112; 212; 312) of said contour and each one being configured to interconnect said piece of equipment (10; 110; 210; 310) with said electronic devices; said piece of equipment (10; 110; 210; 310) being **characterised in that** said first side (11; 111; 211; 311) has a first length and said second side (12; 112; 212; 312) has a second length and at least one of said first length and second length, namely the length of at least one of said first and second sides provided with said plurality of connection ports, is greater than said predetermined distance, the longest first side and/or said second side being either curved or having an edge (21, 121).

2. Piece of equipment according to Claim 1, **characterised in that** said second side (112; 312), third side (113; 313) and fourth side (114; 314) define an internal space (118; 318) in said piece of equipment (110; 310) and said first side (111; 311) extends between said third side (113; 313) and fourth side (114; 314) inside said internal space (118; 318).

3. Piece of equipment according to Claim 1, **characterised in that** said second side (12; 212), third side (13; 213) and fourth side (14; 214) define an internal space (18; 218) in said piece of equipment (10; 210) and said first side (11; 211) extends between said third side (13; 213) and fourth side (14; 214) and projects from said internal space (18; 218).

4. Piece of equipment according to either of Claims 2 and 3, **characterised in that** said first side (11; 11; 211; 311) has a first end joining said third side and a second end opposite said first end and joining said fourth side (514; 114; 214; 314); and said first side (11; 111; 211; 311) projects from said internal space (18; 218) or returns to said internal space (118; 318) and is at a predetermined maximum distance of separation (23; 223) from said internal space (18; 218) or of indentation (123; 323) in said internal space (118; 318) of between approximately 10 mm and approximately 200 mm.

5. Piece of equipment according to Claim 4, **characterised in that** said predetermined maximum distance of separation or indentation (23; 123; 223; 323) is equal to approximately 100 mm.

6. Piece of equipment according to any one of Claims 1 to 5, **characterised in that** said first side (211; 311) extends between said third side (213; 313) and fourth side (214; 314) in a general curved direction.

7. Piece of equipment according to any one of Claims 1 to 5, **characterised in that** said first side (11; 111) extends between said third side (13; 113) and fourth side (14; 114) in a general vertex direction.

8. Piece of equipment according to any one of Claims 1 to 7, **characterised in that** it has a general size of nU, that is to say a second length approximately equal to n times 457.2 mm, a first length of between approximately 1.05 times and 1.5 times said second length.

9. Piece of equipment according to any one of Claims 1 to 8, **characterised in that** said connection ports (30a-f; 130a-f; 230a-f; 330a-f) are of the same type or of different types, particularly of copper type and/or of optical type.

10. Computer cabinet particularly in a hosting centre, having a plurality of pieces of computer equipment (10; 110; 210; 310) according to any one of Claims 1 to 9.
